# EUROPÄISCHE PATENTSCHRIFT

(11) **EP 1 095 285 B1**
(45) Veröffentlichungstag und Bekanntmachung des Hinweises auf die Patenterteilung: **26.03.2003**
(21) Anmeldenummer: 99936474.8
(22) Anmeldetag: 02.07.1999
(51) Int. Cl.: G01R 31/265

(54) **VERFAHREN UND VORRICHTUNG ZUR BESTIMMUNG DER ABHÄNGIGKEIT EINER ERSTEN MESSGRÖSSE VON EINER ZWEITEN MESSGRÖSSE**
METHOD AND DEVICE FOR DETERMINING THE DEPENDENCE OF A FIRST MEASURED QUANTITY ON A SECOND MEASURED QUANTITY
PROCEDE ET DISPOSITIF POUR DETERMINER LA DEPENDANCE D'UNE PREMIERE GRANDEUR DE MESURE PAR RAPPORT A UNE DEUXIEME GRANDEUR DE MESURE

(30) Priorität: 03.07.1998 DE 19831216
(43) Veröffentlichungstag der Anmeldung: 02.05.2001
(73) Patentinhaber: AOTI Operating Company, Inc., Bend, Oregon 97701 (US)
(72) Erfinder: ORSCHEL, Benno, Salem, OR 97302 (US); HELM, Jan, D-10829 Berlin (DE); SROCKA, Bernd, D-13053 Berlin (DE)
(74) Vertreter: Weisse, Jürgen, Dipl.-Phys.
(86) Internationale Anmeldenummer: EP9904617
(87) Internationale Veröffentlichungsnummer: WO00002058

(56) Entgegenhaltungen:
- EP-A- 0 077 021
- EP-A- 0 828 162
- US-A- 5 663 657

## Beschreibung

Die Erfindung betrifft ein Verfahren zur Bestimmung der Abhängigkeit einer ersten Meßgröße von einer zweiten Meßgröße, wobei
(a) die zweite Meßgröße periodisch mit einer Frequenz verändert wird und
(b) die dem entsprechend sich ändernde erste Meßgröße gemessen wird.
   Ein Beispiel für die Anwendung der Erfindung ist die Messung des Oberflächen-Photospanmmg eines Materials als erster Meßgröße in Abhängigkeit von der Wellenlänge des anregenden Lichts als zweiter Meßgröße. Wenn die Oberfläche eines Halbleiters mit Licht beaufschlagt wird, tritt an der Oberfläche des Materials eine Obeflächen-Photospannung auf, die u.a von der Diffusionslänge der Ladungsträger im Material abhängt und ein Maß für diese liefert. Die Oberflächen-Photospannung hängt auch von der Wellenlänge des anregenden Lichts ab. Je langwelliger das Licht ist, desto höher ist das Transmissionsvermögen des Materials für das Licht und desto tiefer dringt das Licht in das Material ein. Die Zusammenhänge zwischen Diffusionslänge und Oberflächen-Photosparmungen sind recht verwickelt. Die Beziehung kann aber näherungsweise linearisiert werden, wenn entweder mit konstanter Intensität des Lichts oder mit konstantem Ausgangssignal gearbeitet wird, die Messung also an definierten Arbeitspunkten erfolgt. Die Messung der Oberflächen-Photospannung kann benutzt werden, um Unregelmäßigkeiten des Materials, z.B. eines Halbleiter-Wafers, zu ermitteln. Zu diesem Zweck wird die Oberflächen-Photospannung des Materials punktweise über die Oberfläche des Materials hinweg untersucht.
   Durch EP-A-0 077 021 ist eine Vorrichtung zum zerstörungsfreien Messen von Eigenschaften eines Halbleiterwafers mittels eines SPV-Verfahrens bekannt. Der Wafer wird mit einem gepulsten Lichtstrahl einer Lichtquelle beaufschlagt. Die Pulsfrequenz des Lichtstrahls ist durch einen Oszillator veränderbar. Der Lichtstrahl erzeugt eine Photospannung an der Oberfläche des Wafers. Diese Photospannung wird durch eine Elektrode kapazitiv abgegriffen. Zur Rauschunterdrückung wird dabei die kapzitiv abgegriffene Photospannung durch einen Lock-In-Verstärker verstärkt. Durch eine Signalverarbeitungseinhet wird die Frequenz des Oscillators (und damit die Pulsfrequenz des Lichtstrahls) bestimmt und überwacht. Durch die Signalverarbeitungseinheit wird weiterhin die gemessene Photospannung in Abhängigkeit von der Pulsfrequenz bestimmt. Dabei wird die Pulsfrequenz des Lichtstrahls stetig erhöht und die Photospannung gemessen. An einem Anzeigegerät wird log Vₚₕ über log f dargestellt. Bei einer kritischen Frequenz ändert sich die Abhängigkeit der Photospannung von der Pulsfrequenz charakteristisch. Diese kritische Frequenz gilt als Maß für die zu ermittelnde Lebensdauer der durch den Lichtstrahl erzeugten Ladungsträger.
   Durch US-A-5 663 657 ist ebenfalls ein SPV-Verfahren zur Untersuchung eines Halbleiterwafers bekannt, wobei die Diffusionslänge von Minoritätsladungsträger bestimmt wird. Ein Bereich des Wafers wird in mehreren Schritten mit Licht unterschiedlicher Wellentänge beaufschlagt und die resultierende Photospannung wird gemessen. Dabei wird die Photospannung in Abhängigkeit von der Eindringtiefe des anregenden Lichtes bestimmt, wobei die Eindringtiefe eine Funktion der Wellenlänge des Lichtes ist.
   Die Oberflächen-Photospannungen sind sehr klein und mit starkem Rauschen behaftet. Die Messung erfolgt daher mittels einer "Lock-in"-Technik. Dabei wird die Intensität des anregenden Lichts mit einer Modulationsfrequenz und -phase moduliert. Das bewirkt eine entsprechende Modulation des Meßsignals, soweit dieses auf der Anregung durch das Licht beruht. Durch eine Fouriertransformation des Meßsignals wird die Komponente des Meßsignals bestimmt, die in Frequenz und Phase der Modulationsfrequenz und - phase entspricht. Damit wird das Rauschen unterdrückt, so daß auch ein sehr schwaches Nutzsignal erfaßt werden kann. Die Messung wird dann für jeden untersuchten Punkt des Materials bei verschiedenen Wellenlängen des anregenden Lichts durchgeführt.
   Dieses Meßverfahren ist sehr langwierig. Bei der Anwendung der Lock-in-Technik ist für jede Messung eine bestimmte Anzahl von Perioden der Modulationsfrequenz, z.B. fünf Perioden, erforderlich. Die Modulationsfrequenz ist begrenzt durch das Material: Es bedarf einer bestimunten Zeit, bis sich in dem Material bei einer Beaufschlagung mit Licht ein Gleichgewichtszustand eingestellt hat und eine Messung der Oberflächen-Photospannung sinnvoll wird. Wenn dann die Messung für jeden abgetasteten Punkt der Oberfläche bei verschiedenen Wellenlängen durchgeführt werden muß und viele Punkte der Oberfläche abgetastet werden sollen, ergibt sich eine untragbar lange Meßzeit. In der Praxis werden daher bei der Prüfung von Halbleiter-Wafern durch Oberflächen-Photospannung nur eine sehr begrenzte Zahl von Maßpunkten bei einer sehr begrenzten Zahl von Wellenlängen vermessen.
   Der Erfindung liegt die Aufgabe zugrunde, hierbei oder bei Verfahren zur Bestimmung der Abhängigkeit einer ersten Meßgröße (Y) von einer zweiten Meßgröße (P), bei denen ähnliche Probleme auftreten, die Meßzeiten zu verkürzen, wobei Rauschen ebenfalls unterdrückt wird.
   Erfindungsgemäß wird diese Aufgabe bei einem Verfahren der eingangs genannten Art dadurch gelöst, daß
(c) aus dem erhaltenen Meßsignal der ersten Meßgröße die Komponenten der ersten Meßgröße mit wenigstens einer Mehrzahl von Frequenzen bestimmt werden und
(d) aus den so bestimmten Komponenten durch Signalverarbeitung die erste Meßgröße für wenigstens eine Mehrzahl von Werten der zweiten Meßgröße rekonstruiert wird.

Es erfolgt nach der Erfindung also nicht -bei dem. Beispiel der Oberflächen-Photospannung- eine Modulation des anregenden Lichts bei vorgegebener Wellenlänge, was zu einer Modulation der Oberflächen-Photospannung als "erster Meßgröße" führt. Vieimehr wird die Wellenlänge des anregenden Lichts als "zweite Meßgröße" periodisch über einen Abtastbereich hinweg mit einer Frequenz f₀ verändert. Das führt zu einem periodischen Meßsignal. Aus diesem Meßsignal werden die Komponenten der Frequenz f₀ und deren höhere Harmonische 2f₀, 3f₀... bis zu einer oberen Grenzfrequenz Nf₀ gewonnen. Auch dabei wird Rauschen unterdrückt. Durch eine inverse Fouriertransformation kann dann aus den so bestimmten Komponenten die erste Meßgröße (z.B. Oberflächen-Photospannung) vom Rauschen befreit in Abhängigkeit von der zweiten Meßgröße (z.B. Wellenlänge) mindestens für eine Mehrzahl von Werten der zweiten Meßgröße rekonstruiert werden.

Dabei kann die Photonendichte des anregenden Lichts in Abhängigkeit von der Wellenlänge zusätzlich gemessen und bei der Rechmmg berücksichtigt werden. Diese Photonendichte kann u.U. einmal gemessen und "eingeeicht" werden. Es kann aber auch eine Bestimmung der Photonendichte und ihrer Abhängigkeit von der Wellenlänge in bestimmten Abständen, nicht notwendig mit der Modulationsfrequenz, wiederholt werden. Es ist aber nicht erforderlich, diese Photonendichte bei den verschiedenen Meßpunkten und Wellenlängen physikalisch auf einen konstanten Wert zu bringen.

Eine bevorzugte Vorrichtung zur Durchführung des Verfahrens ist Gegenstand des Patentanspruchs 9.

Ausgestaltungen der Erfindung sind Gegenstand der abhängigen Ansprüche.

Ausführungsbeispiele der Erfindung sind nachstehend unter Bezugnahme auf die zugehörigen Zeichnungen näher erläutert:
- Fig.1: ist eine schematische Darstellung einer Vorrichtung zur Messung der Abhängigkeit einer ersten Meßgröße (Oberflächen-Photospannung) von einer zweiten Meßgröße (Wellenlänge des anregenden Lichts).
- Fig.2: ist eine schematische Darstellung einer Abwandlung der Vorrichtung von Fig.1 mit einem Kammfilter.
- Fig.3: zeigt eine Abwandlung der Mittel zur periodischen Veränderung der zweiten Meßgröße, nämlich der Wellenlänge des anregenden Lichts.
- Fig.4: zeigt eine weitere Abwandlung der Mittel zur periodischen Veränderung der Wellenlänge, nämlich mittels eines Verlaufsfilters.
- Fig.5: zeigt eine Abwandlung der Ausführung nach Fig.4.
- Fig.6: ist eine schematische Darstellung des mit der Vorrichtung von Fig.1 erhaltenen Meßsignals.
- Fig.7: zeigt schematisch die Fouriertransformierte des Meßsignals von Fig.4.
- Fig.8: zeigt schematisch die aus der Fouriertransformierten von Fig.5 rekonstruierte Abhängigkeit der ersten Meßgröße Y (Oberflächen-Photospannung) von der zweiten Meßgröße P (Wellenlänge des anregenden Lichts).

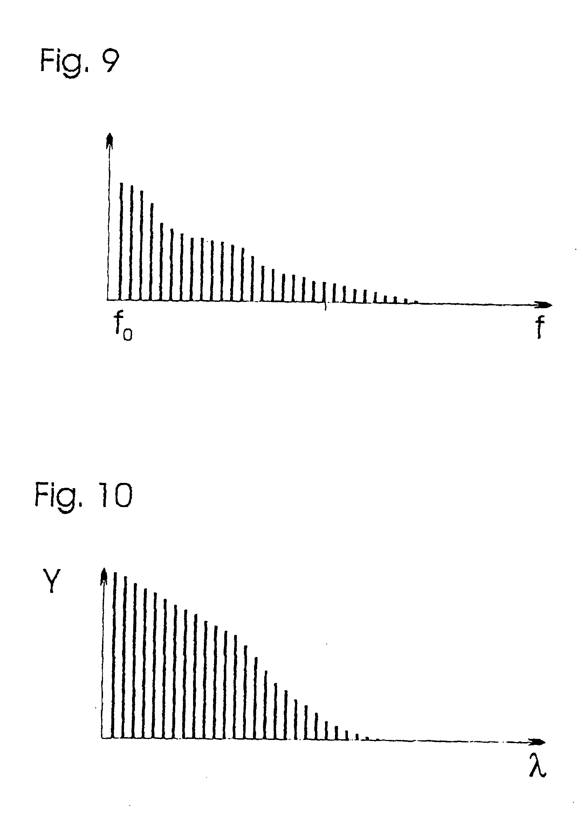

- Fig.9: zeigt schematisch die mit der abgewandelten Meßanordnung mittels des Kammfilters für verschiedene Oberwellen der Modulationsfrequenz erhaltenen Komponenten.
- Fig.10: zeigt schematisch die daraus für die verschiedenen Werte der zweiten Meßgröße (Wellenlängen) rekonstruierten Werte der ersten Meßgröße (Oberflächen-Photospannung).

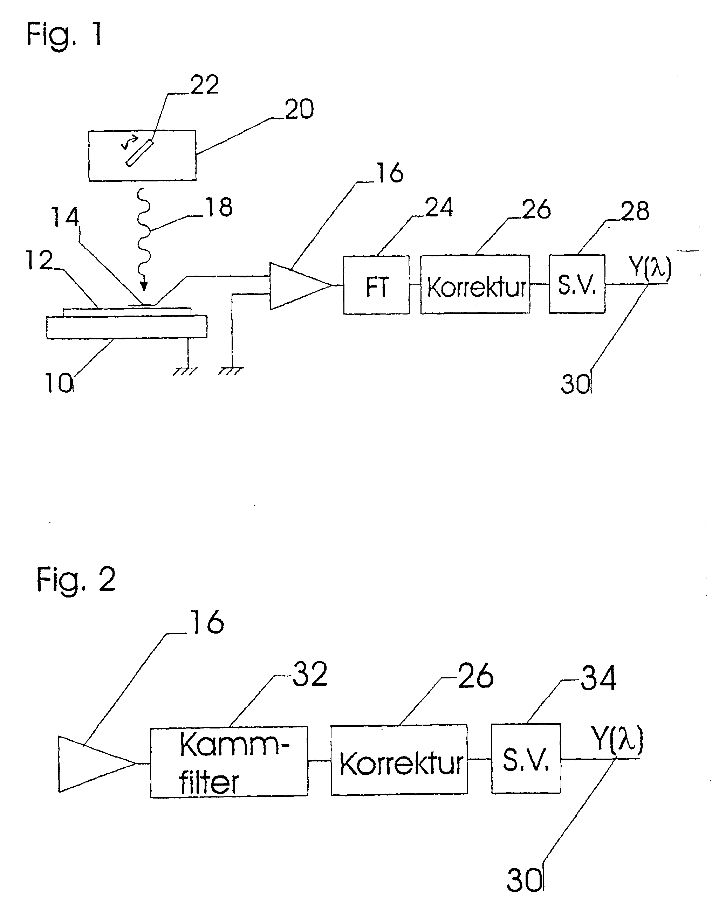

In Fig.1 ist mit 10 ein Probentisch bezeichnet. Auf dem Probentisch 10 ist eine Probe 12 eines zu untersuchenden Halbleitermaterials, z.B. eines Halbleiter-Wafers, aufgespannt. Zur Messung der Oberflächen-Photospannung SPV in den verschiedenen Meßpunkten der Oberfläche der Probe dient eine Sonde 14. Mittels der Sonde 14 wird die Oberflächen-Photospannung SPV gegen Erde abgegriffen. Das sehr schwache Signal wird durch eine Signalvorverarbeitung, die hier als Verstärker 16 dargestellt ist, gefiltert und verstärkt.

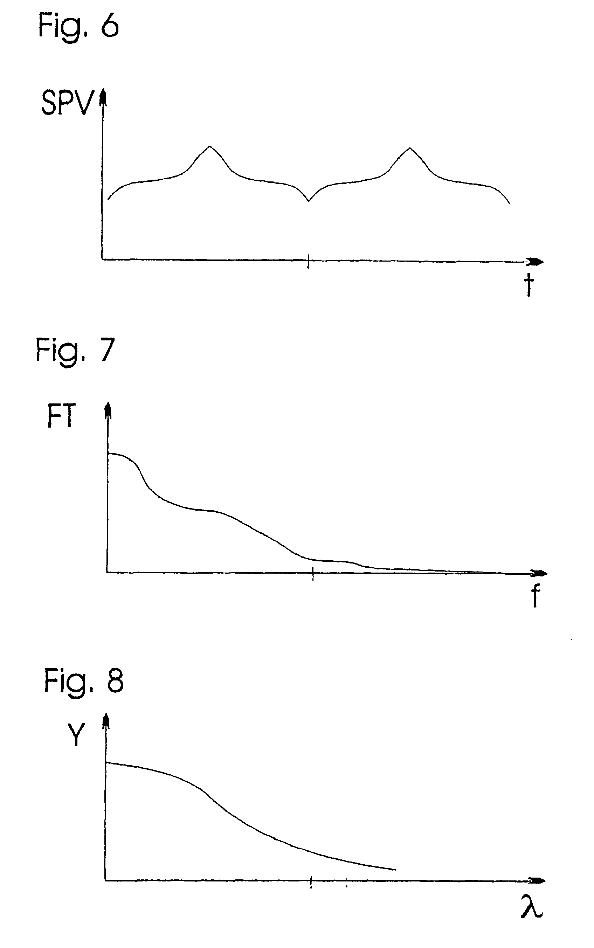

Zur Erzeugung der Oberflächen-Photospannung SPV wird ein Fleck auf der Oberfläche des Materials durch Licht beleuchtet. Das Licht ist hier durch einen Lichtstrahl 18 angedeutet. Das Licht wird von einem Monochromator 20 geliefert. Der Monochromator 20 weist ein harmonisch mit einer Frequenz f₀ schwingendes optisches Glied 22, z.B. ein schwingendes Gitter, auf. Dadurch wird die Wellenlänge λ des anregenden Lichts periodisch mit dieser Frequenz f₀ verändert. Das dadurch erhaltene Meßsignal hat dann etwa den in Fig. 6 dargestellten zeitlichen Verlauf. Das durch den Verstärker 16 verstärkte Meßsignal wird auf Fourier-Transformationsmittel 24 aufgeschaltet. Diese liefern die Fouriertransformierte des Meßsignals. Durch Korrekturmittel 26 wird diese Fouriertransformierte hinsichtlich des Frequenzganges und Phasenganges des Verstärkers 16 korrigiert. Durch eine Signalverarbeitung wird aus dieser korrigierten Fouriertransformierten die Abhängigkeit Y(λ) der ersten Meßgröße, d.h. der Oberflächen-Photospannung SPV, von der zweiten Meßgröße, d.h. der Wellenlänge λ des anregenden Lichts, gewonnen. Diese wird an einem Ausgang 30 ausgegeben. Die so erhaltene Abhängigkeit entspricht etwa Fig.8.

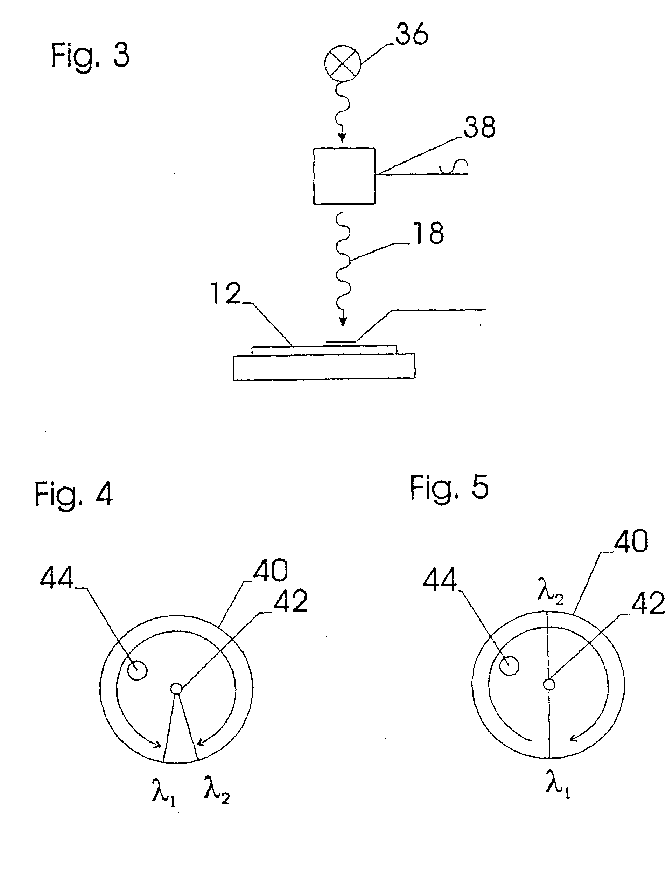

Bei der Abwandlung, die in Fig.2 dargestellt ist, ist das Meßsignal auf ein Kammfilter 32 aufgeschaltet Das Kammfilter 32 liefert jeweils mit hoher Filtergüte die verschiedenen Komponenten des Meßsignals (Fig.4) mit der Modulationsfrequenz f₀ und den Oberwellen 2f₀, 3f₀ usw. Das ist in Fig.7 schematisch dargestellt. Aus diesen Komponenten werden durch eine Signalverarbeitung 34 Werte Yₙ der ersten Meßgröße wie der Oberflächen-Photospannung, für verschiedene diskrete Werte λₙ der zweiten Meßgröße "Wellenlänge" bestimmt. Das ist in Fig.8 schematisch dargestellt.

Bei der Abwandlung der Meßanordnung von Fig.3 wird das anregende Licht mit periodisch variabler Wellenlänge nicht durch einen Monochromator mitt schwingendem optischen Glied erzeugt wie in Fig.1. Vielmehr ist dort eine weiße Lichtquelle 36 vorgesehen, deren Licht durch ein akusto-optisches Transmissionsfilter 38 geleitet wird. Das akusto-optische Transmissionsfilter 38 wird durch ein Sinussignal angesteuert, wodurch der Transmissionsbereich des akusto-optischen Transmissionsfilters nach Maßgabe dieses Signals variiert wird. Dadurch erfolgt eine periodische, sinusförmige Modulation der Wellenlänge des Lichts.

Fig.4 zeigt schematisch eine Anordnung, bei welcher die Wellenlänge des anregten Lichts mittels eines Verlaufsfilters veränderbar ist. Das Verlaufsfilter hat einen ortsabhängigen Transmissionsbereich. Im Fall von Fig.4 ist das Verlaufsfilter eine Scheibe 40, die um eine Achse 42 schwingbeweglich ist, wie durch den Doppelpfeil angedeutet ist. Die Durchlässigkeit der verschiedenen Sektoren der Scheibe ist eine Funktion des Umfangswinkels. Die Durchlässigkeit ändert sich von der Wellenlänge λ₁ über einen Umfangsbereich bis zu einer Wellenlänge λ₂. Bei einer Schwingbewegung bewegen sich die Bereiche von λ₁ bis λ₂ relativ zu dem Bündel von anregender Strahlung.

Bei der Ausführung nach Fig.5 ändern sich die Transmissionsbereiche über jeweils 180° rechtsherum und linksherum zwischen den Wellenlängen λ₁ und λ₂. Die Scheibe 40 braucht dann keine Schwingbewegung auszuführen sondern kann kontinuierlich

Durch Bewegung des Probentisches kann die Probe 12 relativ zu der Sonde 14 und der Lichtquelle 20, 22 bzw. 36, 38 bewegt werden, so daß nacheinander verschiedene Punkte der Probe abgetastet werden können.

## Patentansprüche

1. Verfahren zur Bestimmung der Abhängigkeit einer ersten Meßgröße (Y) von einer zweiten Meßgröße (P), wobei
(a) die zweite Meßgröße (P) periodisch mit einer Frequenz (f₀) verändert wird und
(b) die dementsprechend sich ändernde erste Meßgröße (Y) gemessen wird,
**dadurch gekennzeichnet, daß**
(c) aus dem erhaltenen Meßsignal der ersten Meßgröße (Y) die Komponenten der ersten Meßgröße (Y) mit wenigstens einer Mehrzahl von Frequenzen bestimmt werden und
(d) aus den so bestimmten Komponenten durch Signalverarbeitung die erste Meßgröße (Y) für wenigstens eine Mehrzahl von Werten der zweiten Meßgröße (P) rekonstruiert wird.

2. Verfahren nach Anspruch 1, **dadurch gekennzeichnet, daß** die Veränderung der zweiten Meßgröße nach einer Sinusfunktion erfolgt.

3. Verfahren nach Anspruch 1 oder 2, **dadurch gekennzeichnet, daß** zur Bildung der Komponenten der ersten Meßgröße
(a) das Meßsignal einer Fouriertransformation unterworfen wird und
(b) die Fouriertransformierte des Meßsignals hinsichtlich des Frequenzganges und Phasenganges der Meßanordnung korrigiert wird.

4. Verfahren nach Anspruch 1 oder 2, **dadurch gekennzeichnet, daß** zur Bildung der Komponenten der Meßgröße das Meßsignal auf ein Kammfilter aufgeschaltet wird.

5. Verfahren nach einem der Ansprüche 1 bis 4, **dadurch gekennzeichnet, daß** die erste Meßgröße die Oberflächen-Photospannung eines Materials bei Anregung mit Licht ist, und die zweite Meßgröße die Wellenlänge des anregenden Lichtes ist.

6. Verfahren nach Anspruch 5, **dadurch gekennzeichnet, daß** die Anregung durch Licht eines Monochromators erfolgt, der zur periodischen Veränderung der Wellenlänge ein schwingendes optisches Glied aufweist.

7. Verfahren nach Anspruch 5, **dadurch gekennzeichnet, daß** die Wellenlänge des anregenden Lichts durch ein akusto-optisches Transmissionsfilter (38) periodisch verändert wird.

8. Verfahren nach Anspruch 5, **dadurch gekennzeichnet, daß** die Wellenlänge des anregenden Lichts durch ein Verlaufsfilter verändert wird, dar relativ zu dem anregenden Licht bewegt wird.

9. Vorrichtung zur Durchführung des Verfahrens nach Anspruch 1, **gekennzeichnet, durch**
(a) Mittel (22) zur periodischen Veränderung der zweiten Meßgröße (P) mit einer Frequenz (f₀),
(b) Mittel (14) zur Messung der dementsprechend sich ändernde ersten Meßgröße (Y)
(c) Mittel (24,26;32) zur Bestimmung der Komponenten der ersten Meßgröße (Y) mit wenigstens einer Mehrzahl von Frequenzen aus dem erhaltenen Meßsignal der ersten Meßgröße (Y) und
(d) Signalverarbeitungsmittel (28;34) zum Rekonstruieren der ersten Meßgröße (Y) für wenigstens eine Mehrzahl von Werten der zweiten Meßgröße (P) aus den so bestimmten Komponenten.

10. Vorrichtung nach Anspruch 9, **dadurch gekennzeichnet, daß** die zweite Meßgröße nach einer Sinusfunktion veränderbar ist.

11. Vorrichtung nach Anspruch 9 oder 10, **dadurch gekennzeichnet, daß**
(a) die Mittel zur Bestimmung der Komponenten der ersten Meßgröße (Y) mit wenigstens einer Mehrzahl von Frequenzen aus dem erhaltenen Meßsignal der ersten Meßgröße (Y) Mittel (24) zur Fouriertransformation des Meßsignals enthalten sowie
(b) Mittel (26) zum Korrigieren der Fouriertransformierten des Meßsignals hinsichtlich des Frequenzganges der Meßanordnung.

12. Vorrichtung nach Anspruch 9 oder 10, **dadurch gekennzeichnet, daß** zur Bildung der Komponenten der Meßgröße das Meßsignal auf ein Kammfilter (32) aufgeschaltet ist.

13. Vorrichtung nach einem der Ansprüche 11 oder 12, **dadurch gekennzeichnet, daß** die erste Meßgröße die Oberflächen-Photospannung eines Materials bei Anregung mit Licht ist, und die zweite Meßgröße die Wellenlänge des anregenden Lichtes ist.

14. Vorrichtung nach Anspruch 13, **dadurch gekennzeichnet, daß** zur Erzeugung des anregenden Lichts eines Monochromator (20) vorgesehen ist, der zur periodischen Veränderung der Wellenlänge ein schwingendes optisches Glied (22) aufweist.

15. Vorrichtung nach Anspruch 13, **dadurch gekennzeichnet, daß** zur periodischen Veränderung der Wellenlänge des anregenden Lichts ein akusto-optisches Transmissionsfilter vorgesehen ist.

16. Vorrichtung nach Anspruch 13, **dadurch gekennzeichnet, daß** zur periodischen Veränderung der Wellenlänge des anregenden Lichts ein Verlaufsfilter genutzt wird, welches relativ zum Lichtstrahl bewegt wird.

17. Vorrichtung nach Anspruch 13, **dadurch gekennzeichnet, daß** zur Anregung eine durchstimmbare monochromatische Lichtquelle verwendet wird.

## Claims

1. Method of determining the dependence of a first measuring quantity (Y) on a second measuring quantity (P) wherein
(a) the second measuring quantity (P) is periodically varied at a frequency (f₀), and
(b) the first measuring quantity (Y) varied accordingly is measured,
**characterised in that**
(c) from the measuring signal of the first measuring quantity (Y), the components of the first measuring quantity (Y) of, at least, a plurality of frequencies are determined, and
(d) from the components thus determined, the first measuring quantity (Y) is reconstructed for at least a plurality of values of the second measuring quantity by signal processing.

2. Method as claimed in claim 1, **characterised in that** the variation of the second measuring quantity is effected in accordance with a sine function.

3. Method as claimed in claim I or 2, **characterised in that** for deriving the components of the first measuring quantity
(a) the measuring signal is subjected to a Fourier transformation, and
(b) the Fourier transform of the measuring signal is corrected for the frequency response of the measuring arrangement.

4. Method as claimed in claiml or 2, **characterised in that,** for deriving the components of the measuring quantity, the measuring signal is applied to a comb filter.

5. Method as claimed in anyone of the claims I to 4, **characterised in that** the first measuring quantity is the surface photo-voltage of a material when excited by light, and the second measuring quantity is the wavelength of the exciting light.

6. Method as claimed in claim 5, **characterised in that** the excitation is caused by the light from a monochromator which comprises an oscillating optical element for periodically varying the wavelength.

7. Method as claimed in claim 5, **characterised in that** the wavelength of the exciting light is periodically varied by means of an acousto-optical transmission filter (38).

8. Method as claimed in claim 5, **characterised in that** the wavelength of the exciting light is varied by means of a filter the spectral transmission of which varies across the filter surface, the filter being moved relative to the exciting light.

9. Device for carrying out the method claimed in claim 1, **characterised by**
(a) means (22) for periodically varying the second measuring quantity (P) at a frequency (f₀),
(b) means (14) for measuring the accordingly varying first measuring quantity (Y),
(c) means (24,26;32) for determining, from the measuring signal of the first measuring quantity thus obtained, the components of the first measuring quantity (Y) of at least a plurality of frequencies, and
(d) signal processing means (28;34) for reconstructing the first measuring quantity (Y) for at least a plurality of values of the second measuring quantity (P) from the components thus determined.

10. Device as claimed in claim 9, **characterised in that** the second measuring quantity is variable in accordance with a sine function.

11. Device as claimed in claim 9 or 10, **characterised in that**
(a) the means for determining the components of the first measuring quantity (Y) of at least a plurality of frequencies from the measuring signal obtained of the first measuring quantity (Y) comprise means (24) for Fourier transforming the measuring signal, as well as
(b) means (26) for correcting the Fourier transform of the measuring signaöl for the frequency response of the measuring arrangement.

12. Device as claimed in claim 9 or 10, **characterised in that,** for deriving the components of the measuring quantity, the measuring signal is applied to a comb filter (32).

13. Device as claimed in anyone of the claims 11 or 12, **characterised in that** the first measuring quantity is the surface photo-voltage of a material, when the material is excited by light, and the second measuring quantity is the wavelength of the exciting light.

14. Device as claimed in claim 13, **characterised in that** a monochromator (20) is provided for generating the exciting light, the monochromator comprising an oscillating optical element (22) for periodically varying the wavelength.

15. Device as claimed in claim 13, **characterised in that** an acousto-optical transmission filter is provided for varying the wavelength of the exciting light.

16. Device as claimed in claim 13, **characterised in that** a filter the spectral transmission of which varies across the filter surface is used for periodically varying the wavelength of the exciting light, this filter being moved relative to the beam of light.

17. Device as claimed in claim 13, **characterised in that** a tuneable monochromatic light source is used for the excitation.

## Revendications

1. Procédé destiné à déterminer la dépendance d'une première grandeur de mesure (Y) d'une seconde grandeur de mesure (P),
(a) la seconde grandeur de mesure (P) étant modifiée périodiquement avec une fréquence (f₀) et
(b) la première grandeur de mesure (Y) modifiée suite à cela étant mesurée,
**caractérisé en ce que**
(c) les composantes de la première grandeur de mesure (Y) sont déterminées avec au moins plusieurs fréquences à partir du signal de mesure obtenu de la première grandeur de mesure (Y) et
(d) la première grandeur de mesure (Y) est reconstituée pour au moins plusieurs valeurs de la seconde grandeur de mesure (P) à partir des composantes ainsi déterminées par traitement de signaux.

2. Procédé selon la revendication 1, **caractérisé en ce que** la modification de la seconde grandeur de mesure se fait d'après une fonction sinusoïdale.

3. Procédé selon la revendication 1 ou 2, **caractérisé en ce que**, en vue de la formation des composantes de la première grandeur de mesure,
(a) le signal de mesure subit une transformation de Fourier et
(b) la transformée de Fourier du signal de mesure est corrigée en fonction de la réponse en fréquence et de la réponse en phase de la disposition de mesure.

4. Procédé selon la revendication 1 ou 2, **caractérisé en ce que**, en vue de la formation des composantes de la grandeur de mesure, le signal de mesure est appliqué à un filtre en peigne.

5. Procédé selon l'une des revendications 1 à 4, **caractérisé en ce que** la première grandeur de mesure est la phototension superficielle d'un matériau lorsqu'il est excité par de la lumière, et la seconde grandeur de mesure est la longueur d'ondes de la lumière d'excitation.

6. Procédé selon la revendication 5, **caractérisé en ce que** l'excitation se fait par la lumière d'un monochromateur présentant un élément optique oscillant destiné à modifier périodiquement la longueur d'ondes.

7. Procédé selon la revendication 5, **caractérisé en ce que** la longueur d'ondes de la lumière d'excitation est modifiée périodiquement par un filtre de transmission acousto-optique (38).

8. Procédé selon la revendication 5, **caractérisé en ce que** la longueur d'ondes de la lumière d'excitation est modifiée par un filtre dont la perméabilité varie sur toute sa surface et qui est déplacé par rapport à la lumière d'excitation.

9. Dispositif destiné à réaliser le procédé selon la revendication 1, **caractérisé par**
(a) des moyens (22) destinés à modifier périodiquement la seconde grandeur de mesure (P) avec une fréquence (f₀),
(b) des moyens (14) destinés à mesurer la première grandeur de mesure (Y) modifiée suite à cela,
(c) des moyens (24,26;32) destinés à déterminer les composantes de la première grandeur de mesure (Y) avec au moins plusieurs fréquences à partir du signal de mesure obtenu de la première grandeur de mesure (Y) et
(d) des moyens de traitement de signaux (28;34) destinés à reconstituer la première grandeur de mesure (Y) pour au moins plusieurs valeurs de la seconde grandeur de mesure (P) à partir des composantes ainsi déterminées.

10. Dispositif selon la revendication 9, **caractérisé en ce que** la seconde grandeur de mesure est susceptible d'être modifiée d'après une fonction sinusoïdale.

11. Dispositif selon la revendication 9 ou 10, **caractérisé en ce que**
(a) les moyens destinés à déterminer les composantes de la première grandeur de mesure (Y) avec au moins plusieurs fréquences à partir du signal de mesure obtenu de la première grandeur de mesure (Y) comprennent des moyens (24) destinés à la transformation de Fourier du signal de mesure ainsi que
(b) des moyens (26) destinés à corriger la transformée de Fourier du signal de mesure en fonction de la réponse en fréquence de la disposition de mesure.

12. Dispositif selon la revendication 9 ou 10, **caractérisé en ce que,** en vue de la formation des composantes de la grandeur de mesure, le signal de mesure est appliqué à un filtre en peigne (32).

13. Dispositif selon l'une des revendications 11 ou 12, **caractérisé en ce que** la première grandeur de mesure est la phototension superficielle d'un matériau lorsqu'il est excité par de la lumière, et la seconde grandeur de mesure est la longueur d'ondes de la lumière d'excitation.

14. Dispositif selon la revendication 13, **caractérisé en ce que,** en vue de la génération de la lumière d'excitation, il est prévu un monochromateur (20) présentant un élément optique oscillant (22) destiné à modifier périodiquement la longueur d'ondes.

15. Dispositif selon la revendication 13, **caractérisé en ce que**, en vue de la modification périodique de la longueur d'ondes de la lumière d'excitation, il est prévu un filtre de transmission acousto-optique.

16. Dispositif selon la revendication 13, **caractérisé en ce que,** en vue de la modification périodique de la longueur d'ondes de la lumière d'excitation, un filtre dont la perméabilité varie sur toute sa surface et qui est déplacé par rapport au rayon de lumière est utilisé.

17. Dispositif selon la revendication 13, **caractérisé en ce que**, en vue de l'excitation, une source de lumière monochromatique à fréquence variable est utilisée.
